# EUROPEAN PATENT APPLICATION

(11) **EP 3 805 833 A1**
(43) Date of publication of application: **14.04.2021**
(21) Application number: 19202213.5
(22) Date of filing: 09.10.2019
(51) Int. Cl.: G02B 19/00, H01L 23/00, H01L 33/58, H01L 33/60, H05K 3/30

(54) **LIGHTING DEVICE AND METHOD FOR MANUFACTURING A LIGHTING DEVICE**

(71) Applicant: Lumileds Holding B.V., 1118 CL Schiphol (NL)
(72) Inventor: The designation of the inventor has not yet been filed
(74) Representative: ter Heegde, Paul Gerard Michel

(57) **Abstract**

According to the invention a lighting device (100) is provided, comprising: a base structure (110); at least one light emitting element (120) arranged on the base structure (110); at least one optical element (130) assigned to the at least one light emitting element (120); a frame structure (140) configured to define at least a lateral position of the at least one optical element (130) relative to the at least one light emitting element (120); wherein the frame structure (140) is mounted to the base structure (110) and configured to support the at least one optical element (130) at least in lateral alignment with the at least one light emitting element (120).

## Description

### FIELD OF THE INVENTION

The present disclosure relates to a lighting device, in particular to an LED based lighting device for example for vehicular applications, and to a method of manufacturing the lighting device.

### BACKGROUND OF THE INVENTION

Lighting devices based on light emitting elements such as light emitting diodes (LEDs) are often manufactured using surface-mount technology where electronic components including the LEDs are mounted or placed directly onto the surface of a base structure such as a printed circuit board (PCB). An advantage of surface-mount technology for manufacturing lighting devices is a simplified and more rapid process as for example compared to through-hole technology processes.

However, while in particular surface-mount technology allows for positioning e.g. of LEDs with satisfactory precision on a corresponding PCB, a subsequent precise alignment of optical components relative to the LEDs remains difficult. Such precise alignment is however in particular desirable e.g. in case of optical components in form of light guides for LEDs in matrix LED arrangements. Such matrix LED arrangements turned out to be of particular advantage for vehicular applications such as automotive headlight applications where selectively switching and/or dimming of individual LEDs allows for precisely tuning headlight light beams to avoid undesirable glare on oncoming traffic. In order to compensate for a Lambertian emission of LEDs included in a matrix LED arrangement and to thus maximize the amount of light directed onto the road, pre-collimating optical elements, in particular light guides, are used that are individually assigned to individual LEDs and are arranged in close proximity to the respective LEDs. In order to optimize an effect of such light guides, it is desirable to arrange the same in close proximity with respect to a light emitting surface of respective LEDs (vertical/axial alignment), whereby a precision of a lateral alignment of each light guide with respect to a corresponding LED becomes more critical the closer the light guide is placed with respect to the LED. It is noted that in the context of the present disclosure, vertical or axial alignment refers to an alignment in a direction e.g. vertical to a light emitting surface of an LED die or more generally to a light emission direction of a corresponding lighting device.

WO 2007/054868 A2 discloses a method for aligning optical components with respect to LEDs by first fixing a position of individual support elements with respect to the LEDs using a carrier structure, soldering each of the support elements and the LEDs onto a substrate, removing the carrier structure and then placing respective optical components onto corresponding support elements.

### SUMMARY OF THE INVENTION

It is an object of the present invention to provide an improved method for securely aligning optical elements with respect to corresponding light emitting elements. It is a further object of the present invention to provide an improved support structure ensuring precise alignment of optical elements with respect to corresponding light emitting elements during a lifetime of a corresponding lighting device.

According to a first aspect of the present invention, a lighting device is provided comprising a base structure; at least one light emitting element arranged on the base structure; at least one optical element assigned to at least one light emitting element; a frame structure configured to define at least a lateral position of the at least one optical element relative to the at least one light emitting element; wherein the frame structure is mounted to the base structure and configured to support the at least one optical element at least in lateral alignment with the at least one light emitting element.

According to a second aspect of the present invention, a method for manufacturing a lighting device according to the first aspect of the present invention is provided, the method comprising: providing the at least one light emitting element and the base structure; arranging the at least one light emitting element on the base structure; providing the at least one optical element assigned to the at least one light emitting element; providing the frame structure configured to define at least the lateral position of the at least one optical element relative to the at least one light emitting element; mounting the frame structure to the base structure to support the at least one optical element at least in lateral alignment with the at least one light emitting element.

Exemplary embodiments of the first and second aspect of the invention may have one or more of the properties described below.

In an exemplary embodiment, the base structure comprises or consists of an essentially flat support or substrate comprising or consisting of an essentially flat mounting portion onto which the at least one light emitting element is mounted. For example, the substrate or support may comprise or consist of a printed circuit board (PCB). In an exemplary embodiment, the at least one light emitting element is a light emitting diode (LED). Thus, in an exemplary embodiment, the base structure comprises or consists of a PCB electrically connected to the at least one light emitting element, in particular to at least one LED. For example, at least one LED may be mounted to the PCB via a surface-mount and/or flip chip mounting process. To this end, the PCB may be provided with contact pads onto which corresponding contacts of the LED are soldered, e.g. in a reflow soldering process, to establish an electrical connection.

In accordance with the aspects of the present invention, one optical element may be assigned to a corresponding one light emitting element, or one optical element may be assigned to a corresponding plurality of light emitting elements. Thereby, being assigned to at least one light emitting element is to be understood such that the at least one optical element is arranged within the lighting device in order to act on light, in particular to collect light, in particular to collect more than half of the light, emitted from the at least one light emitting element. For example, the optical element may be arranged to collect light emitted from one or more light emitting elements. Thus, in an exemplary embodiment, the at least one optical element is a collimator, in particular a micro-collimator, in particular a light guide. In embodiments where the lighting device comprises multiple light emitting elements, a respective optical element may for example be assigned to each light emitting element, or one optical element (e.g. an elongated blade-shaped collimator) may be assigned to a sub-group of or to a plurality of light emitting elements. For example, a blade-shaped collimator may be assigned to a row of LEDs, whereby several blade-shaped collimators may be placed in parallel, respectively being assigned to corresponding rows of LEDs.

In an exemplary embodiment, the frame structure comprises or consists of or is an essentially flat member, in particular comprising or consisting of a metal or plastic material. Being configured to define at least a lateral position of the at least one optical element is to be understood such that the frame structure is configured to support the at least one optical element laterally relative to the at least one light emitting element, in particular to define the position of a light input face of the optical element in a plane parallel to a light emitting surface of the at least one light element. It is noted that while the frame structure is in principle capable of holding the optical element alone, a further appropriate holder for the at least one optical element may be provided which serves to carry the main weight of the at least one optical element while the frame structure serves to confine the lateral and, optionally, the vertical position of the at least one optical element with respect to the base structure, e.g. the PCB.

Thereby, in an exemplary embodiment, laterally is to be understood as corresponding to directions essentially parallel to the flat mounting portion onto which the at least one light emitting element is mounted. In an exemplary embodiment, the frame structure is further configured to define a vertical position of the at least one optical element with respect to the at least one light emitting element. Thus, the frame structure advantageously acts as alignment mask which on the one hand defines a lateral (in particular also a vertical/axial) position of the at least one optical element with respect to the at least one light emitting element in particular when mounting the at least one optical element. According to the first aspect of the present invention, the frame structure is, in particular in a permanent manner, mounted to the base structure. Thus, the frame structure not only advantageously facilitates precise alignment of the at least one optical element upon mounting, but the frame structure further acts as advantageous supporting or holding frame securing precise alignment of the at least one optical element when mounted.

It is further noted that a lateral alignment may be understood to correspond to an alignment in one lateral direction. For example, in the case of the above mentioned blade-shaped collimators, the frame structure may comprise respective elongated alignment slots for receiving corresponding blade-shaped collimators and for thus securing in particular an alignment in a lateral direction perpendicular to the respective alignment slot (while at the same time securing an alignment, however, maybe not that precise, also in a lateral direction along the slot direction). Further, in an example in which the at least one optical element corresponds to a single respective light emitting element, the optical elements may correspond to collimators with essentially circular cross-section and the frame structure may comprise essentially circularly shaped openings for receiving the respective collimators. In such case, the frame structure secures alignment in all lateral directions.

It turned out that by providing the frame structure, it becomes possible to securely support the at least one optical element such that a highly precise lateral alignment can be guaranteed which in turn allows to arrange the at least one optical element and the at least one light emitting element at a very small mutual vertical distance at which a precise lateral alignment is of high importance. In other words, vertical/axial distances between a light emitting surface of the at least one light emitting element and a light input face of the at least one optical element can be as small as less than 100 µm, in particular less than 70 µm. In other words, in an exemplary embodiment, a distance between a light emitting surface of the at least one light emitting element and a light input face of the at least one optical element is less than 100 µm, in particular less than 70 µm. Being able to allow for such a small distance between the at least one light emitting element and the at least one optical element turned out to greatly improve the amount of light emitted from the at least one light emitting element that can be coupled into the at least one optical element.

In an exemplary embodiment, the lighting device further comprises at least one spacer element mounted to the base structure, wherein the frame structure is mounted to the base structure via the at least one spacer element at a distance from the base structure defined by the at least one spacer element. In other words, the at least one spacer element is arranged in between the base structure and the frame structure, in particular in direct mechanical contact with the base structure and the frame structure. Providing the at least one spacer element on the one hand enables securely defining a relative distance between the frame structure and the base structure which may then secure a stable vertical alignment of the at least one optical element with respect to the at least one light emitting element by means of the frame structure. On the other hand, such spacer element advantageously contributes to an overall stability of mounting the frame structure to the base structure and thus in any case secures lateral alignment of the at least one optical element with respect to the at least one light emitting element. In a preferred embodiment, the at least one spacer element is a surface-mounted device (SMD), i.e. is mounted to the base structure via surface-mount technology. This embodiment facilitates producing the lighting device in a fast and precise way, while miniaturized, in particular prefabricated, components, e.g. the at least one spacer elements, can be used, which further facilitates the manufacturing process of the light emitting device.

In an exemplary embodiment, the base structure comprises or consists of an essentially flat mounting portion onto which the at least one light emitting element is mounted, and wherein the frame structure is arranged essentially parallel to the mounting portion at the distance defined by the at least one spacer element. For example, the base structure may comprise or consist of a PCB onto which the at least one light emitting element, in particular the at least one LED, is mounted. By providing the frame structure essentially parallel to the mounting portion, it becomes advantageously possible to arrange a plurality of optical elements at a same predefined distance with respect to corresponding light emitting elements.

In an exemplary embodiment, the frame structure comprises at least one supporting opening configured to support the at least one optical element at least in lateral alignment with the at least one light emitting element. Such supporting opening is of particular advantage as it facilitates supporting the at least one optical element in a plurality of lateral directions (e.g. directions essentially parallel to the mounting portion onto which the at least one light emitting element is mounted), whereby undesirable inhomogeneous holding or mounting forces onto portions of the at least one optical element are prevented. In turn, such mount thus prevents inhomogeneous deformation of the at least one optical element which could lead to undesirable influence on the optical properties of the at least one optical element (e.g. which could deteriorate total internal reflection properties of a light guide). At the same time, providing a supporting opening enables a particularly secure and stable mount for the at least one optical element.

In an exemplary embodiment, the frame structure comprises at least one alignment opening and wherein the at least one spacer element comprises at least one guiding element which extends from the at least one spacer element through the at least one alignment opening. For example, the guiding element may comprise or consist of a guiding pin, e.g. a rod shaped member. By providing such guiding element, precision of lateral alignment of the frame structure with respect to the at least one spacer element and thus with respect to the base structure and the at least one light emitting element mounted thereto is greatly enhanced as the interplay between guiding element and alignment opening provides a highly precise means for laterally aligning the respective components. At the same time, by keeping the guiding element in engagement with the alignment opening, the precise lateral alignment is secured throughout the lifetime of the lighting device.

Thus, in an exemplary embodiment, the frame structure comprises at least one (e.g. three) first alignment opening which is configured to prevent relative movement of a guiding element extending from the at least one spacer element through the at least one first alignment opening. For example, a cross-section of the first alignment opening may be closely matched to a corresponding cross-section of the alignment element. In an exemplary embodiment, the frame structure further comprises at least one second alignment opening configured to allow for a relative movement of a guiding element extending from a further spacer element through the at least one second alignment opening within a predefined range. For example, a cross-section of the at least one second alignment opening may be larger than a corresponding cross-section of the alignment element. In an exemplary embodiment, the at least one second alignment opening is essentially slot shaped. While a provision of the at least one first alignment opening facilitates providing and securing a precise lateral alignment of the frame structure with respect to the base structure and the at least one light emitting element, by providing the at least one second alignment opening movement of the frame structure caused e.g. by thermal expansion due to heat generated by the at least one light emitting element during operation can be advantageously compensated. Thereby, damage is prevented that may be caused by such thermal expansion and lifetime of the corresponding components is enhanced.

In an exemplary embodiment, the at least one guiding element is formed integrally with the at least one spacer element. By providing the at least one spacer element and the at least one guiding element as an integral component, on the one hand, stability of mounting the frame structure to the base structure is improved, while, on the other hand, minimizing the number of components enhances an achievable precision in lateral alignment.

In an exemplary embodiment, the at least one spacer element is formed integrally with the frame structure. While the at least one spacer element may be a separate component, e.g. an SMD component, in the present embodiment, the frame structure and the at least one spacer element are integrally formed, e.g. by being deep-drawn from a single piece of sheet-metal, by being milled from bulk material (e.g. metal or plastic material) or by being molded. In particular, forming the frame structure and the at least one spacer element integrally by deep-drawing is advantageous in terms of a simple and fast production process.

In an exemplary embodiment, the at least one optical element comprises a micro-collimator, in particular a light guide, arranged in direct or indirect mechanical contact with a light emitting surface of the at least one light emitting element. In a preferred embodiment, the at least one optical element is not in optical contact with the light emitting surface, i.e. an air gap may be present between a light input surface of the at least one optical element and the light emitting surface. Hereby, light emitting surface may be understood as being an outermost surface of a light emitting element, e.g. of an LED, from which light is emitted. For example, the light emitting surface may correspond to an outer surface of a directly emitting LED die or an outer surface of a phosphor layer placed on an LED for wavelength conversion. While the at least one optical element may be placed in direct contact with the light emitting surface, in an exemplary embodiment, the at least one optical element is arranged in indirect mechanical contact with the light emitting surface, whereby a separator sheet is arranged directly in between the at least one optical element and the light emitting surface.

It turned out that in particular the provision of a separator sheet advantageously improves, among other by providing a very small and defined distance between the light emitting surface of the light emitting element and the light input surface of the optical element, an optical coupling between the at least one light emitting element and the at least one optical element, i.e. enhances the amount of light emitted from the at least one light emitting element and coupled into the at least one optical element. In an exemplary embodiment, the separator sheet is a sheet of glass, in particular having a thickness of 50 µm or less, in particular 30 µm or less. For example, in particular in case that the at least one optical element is made of silicone, it turned out that the provision of a thin glass separator sheet advantageously enhances optical coupling between the at least one light emitting element and the at least one optical element. An exemplary separator sheet is disclosed in non-published European patent application with application number EP18213876.8.

In an exemplary embodiment, the at least one optical element, in particular the light guide, comprises or consists of transparent silicone. Use of transparent silicone turned out to be of particular advantage as it is able to withstand high temperatures that may exist close to the at least one light emitting element, in particular the at least one LED, which during operation of the at least one light emitting element may permanently reach e.g. 150°C. At the same time, transparent silicone is advantageous as it can be manufactured into desired shapes in less complex and more cost efficient processes as e.g. glass.

In an exemplary embodiment, the lighting device comprises a plurality of light emitting elements forming a matrix arrangement on the base structure. Thereby, a matrix arrangement is to be understood as including one dimensional matrix arrangements (rows), in particular of equidistantly arranged light emitting elements, as well as two dimensional matrix arrangements. As mentioned above, such matrix arrangements of light emitting elements, in particular of LEDs, turned out to be of particular advantage for vehicular applications such as automotive headlight applications where selectively switching and/or dimming of individual LEDs allows for precisely tuning headlight light beams to avoid undesirable glare on oncoming traffic. Further, in particular in this embodiment, the base structure preferably comprises or consists of a printed circuit board for electrically controlling the at least one light emitting element, in particular the at least one LED, wherein the flat mounting portion corresponds to the printed circuit board.

In the exemplary embodiment, the lighting device further comprises a plurality of optical elements, in particular of micro-collimators and/or light guides, wherein each of the optical elements is assigned to a single corresponding light emitting element and wherein the plurality of optical elements forms a (one dimensional or two dimensional) matrix arrangement in correspondence with the matrix arrangement of light emitting elements, in particular the LEDs.

In the exemplary embodiment, the frame structure comprises a plurality of supporting openings, each supporting opening supporting a corresponding one of the optical elements at least in lateral alignment with its corresponding (or assigned) light emitting element. Thereby, each of the optical elements comprises a light guide arranged in direct or indirect mechanical contact with a light emitting surface of a corresponding one of the light emitting elements.

Thus, in the latter exemplary embodiment, the lighting device comprises a matrix arrangement of light emitting elements with corresponding optical elements, in particular light guides, such that in this embodiment the lighting device is particularly suitable as light source for an automotive headlight.

In an exemplary embodiment of the second aspect of the present invention, the at least one spacer element is mounted to the base structure using a surface-mount technology mounting process. As explained above, in particular using surface-mount technology when mounting components of the lighting device is of particular advantage as it allows for fast and highly precise manufacturing. In particular, mounting the at least one spacer element using a surface-mount technology, in particular mounting the at least one spacer element further comprising the at least one guiding element, allows to achieve a positioning accuracy which is comparable to the high accuracy in mounting the at least one light emitting element using surface-mount technology. Thus, an overall precision and accuracy of mounting these components enables a highly precise lateral alignment of the at least one optical element laterally aligned with the at least one light emitting element via the frame structure which is mounted to the base structure preferably via the at least one spacer element.

The features and example embodiments of the invention described above may equally pertain to the different aspects according to the present invention. In particular, with the disclosure of features relating to the lighting device according to the first aspect, also corresponding features relating to the method for producing the lighting device according to the second aspect are disclosed.

It is to be understood that the presentation of embodiments of the invention in this section is merely exemplary and non-limiting.

Other features of the present invention will become apparent from the following detailed description considered in conjunction with the accompanying drawings. It is to be understood, however, that the drawings are designed solely for purposes of illustration and not as a definition of the limits of the invention, for which reference should be made to the appended claims. It should be further understood that the drawings are not drawn to scale and are merely intended to conceptually illustrate the structures and procedures described herein.

### BRIEF DESCRIPTION OF THE DRAWINGS

Examples of the invention will now be described in detail with reference to the accompanying drawing, in which:
- Fig. 1a: shows a schematic illustration of a lighting device;
- Fig. 1b: shows another schematic illustration of the lighting device of Fig. 1a;
- Fig. 2a: shows a schematic illustration of aspects of a lighting device with a frame structure according to an embodiment of the present invention;
- Fig. 2b: shows another schematic illustration of the lighting device of Fig. 2a;
- Fig. 3: shows a schematic illustration of aspects of a lighting device with a frame structure according to a further embodiment of the present invention; and
- Fig. 4: shows a schematic illustration of aspects of a lighting device with a frame structure according to a still further embodiment of the present invention.

### DETAILED DESCRIPTION OF THE EMBODIMENTS

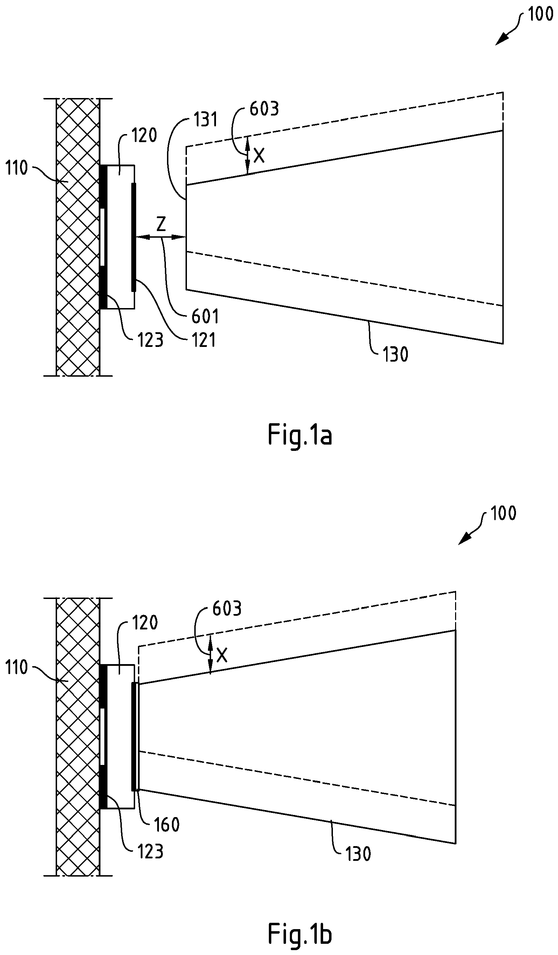

Fig. 1a shows a schematic illustration of a lighting device 100 with a light emitting diode (LED) 120 (an example of a light emitting element) mounted to a printed circuit board (PCB) 110 (an example of a base structure) via a surface-mount technology process, where solder connections 123 between electrical contacts of the LED 120 and corresponding electrical contacts of the PCB 110 have been established by means of a reflow soldering process.

A light guide (an example of an optical element) 130 is provided to collimate light emitted from a light emitting surface 121 of LED 120. In the case shown in Fig. 1, the light guide 130 is held at a relatively large vertical distance (in a vertical alignment or z-direction indicated by arrow 601) of e.g. 150 µm between the light emitting surface 121 of LED 120 and a light input face 131 of light guide 130. Arrow 603 indicates an x-direction as an example of a lateral alignment direction. A further example is a corresponding y-direction perpendicular to the drawing plane of the figure.

Fig. 1b shows the lighting device 100 of Fig. 1a, where a vertical distance between light guide 130 and LED 120 has been minimized such that the light guide 130 is in indirect mechanical contact with the light emitting surface 121 of LED 120 being separated from the LED 120 via a thin glass separator sheet 160.

As explained above, while a minimized vertical distance between the light emitting surface 121 of LED 120 and the light input face 131 of the light guide 130 and the use of the glass separator sheet 160 improve an optical coupling between LED 120 and light guide 130, a precise lateral alignment of the light guide 130 with respect to the LED 120 becomes more important with reduced vertical distance between these components. This is apparent from the fact that a same lateral displacement Δx, Δy in x- and y-direction (indicated in Figs. 1a, 1b, for the x-direction, by the dashed lines), with decreasing distance in z-direction, leads to a serious reduction of the opening angle of the cone of light collected by light input face 131 from light emitting surface 121.

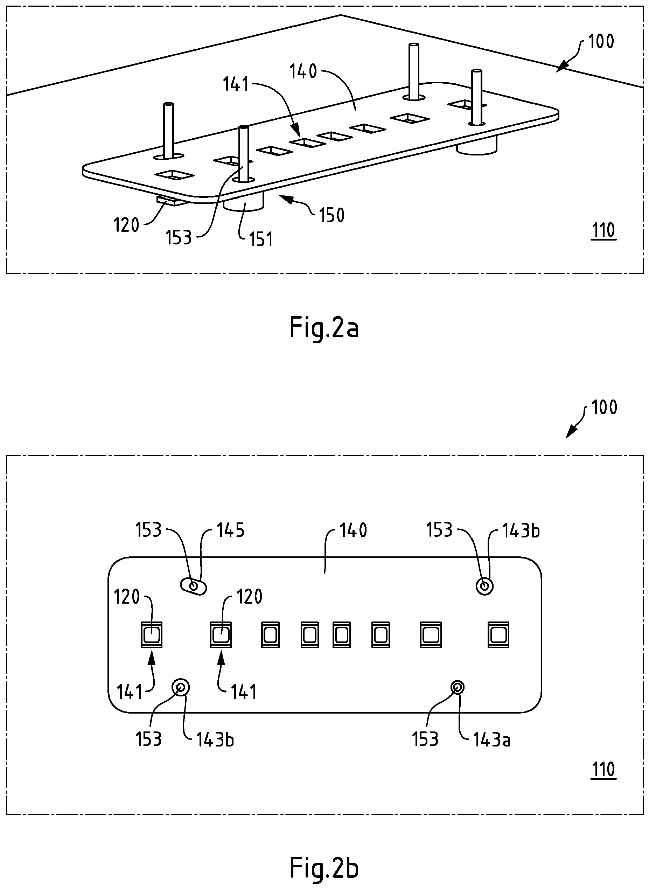

Fig. 2a shows aspects of a lighting device 100 with a frame structure 140 according to an embodiment of the present invention. As shown in the figure, the frame structure 140 is mounted to the PCB 110 via (separate) carrier elements 150 comprising a spacer element 151 with an alignment pin (an example of an alignment element) 153. The frame structure 140 comprises supporting openings 141 forming a one dimensional matrix arrangement in correspondence with a one dimensional matrix arrangement of LEDs 120 mounted to PCB 110 underneath the frame structure 140. The supporting openings 141 are configured to support respective light guides (not shown in the figure) in lateral alignment (i.e. in directions essentially parallel to the PCB 110). It is noted that while the frame structure 140 may hold and support light guides inserted into the corresponding supporting openings 141, a separate light guide holder (not shown) may be provided to support and carry the main weight of the light guides while in such case, the frame structure nevertheless defines the lateral and, optionally, the vertical alignment of the light guides with respect to the LEDs 120 and the PCB 110.

Thus, the frame structure 140 acts as alignment mask which is mounted and referenced to the PCB 110. Via frame structure 140, alignment of light guides with respect to corresponding LEDs 120 becomes possible in a highly precise manner, as referencing of the frame structure 140 with respect to the PCB 110 only depends on a precise positioning of carrier elements 150. Carrier elements 150 are in an exemplary embodiment SMD-components which can be positioned with a very high lateral accuracy comparable to the accuracy in positioning the LEDs 120 on PCB 110. While thus precise alignment of the light guides becomes possible by precisely referencing the frame structure 140 with respect to the PCB via positioning of carrier elements 150, in turn, production and placement accuracy of the mentioned separate holder for the light guides (not shown) could be relaxed enabling a less complex production and alignment of the same.

As shown in Fig. 2a, carrier elements 150 comprise alignment pins 153 on spacer elements 151, the two being integrally formed. Alignment pins 153 of carrier elements 150 shown in Fig. 2a enable a particularly advantageous and highly precise manufacturing process of lighting device 100. First, dedicated, preferably SMD-mountable carrier elements 150 are provided and soldered or glued to PCB 110 preferably via an SMD-mounting process. In this way, e.g. carrier elements 150 may be positioned on the PCB 110 with an accuracy of e.g. 50µm. In a next step, frame structure 140 is provided. As shown in the plan view of Fig. 2b, frame structure 140 comprises an alignment opening 143a (first alignment opening) that are configured to prevent a relative movement of the frame structure 140 relative to the alignment pins 153 when inserted into the corresponding alignment opening, two further and more wide openings 143b that are large enough to allow for some restricted movement of alignment pins in a lateral direction, as e.g. caused by thermal expansion during operation of the light emitting elements, and a third essentially slot shaped alignment opening 145 (second alignment opening). In the shown example, a clearance between alignment opening 143a and an inserted alignment pin 153 may be on the order of ±20µm. Further, the alignment opening 145 (second alignment opening) is configured to allow for a relative movement of a corresponding alignment pin 153 when inserted. As shown in the figure, to this end, the alignment opening 145 is essentially slot shaped and thus guides a thermal expansion of frame structure 140 when heated by LEDs 120 when operated. Frame structure 120 is in an exemplary embodiment a member formed of metal, e.g. a sheet metal member, which is e.g. cut using a laser cutting process.

After frame structure 120 is mounted to PCB 110 by fitting the alignment holes 143a, 143b, 145 onto the corresponding alignment pins 153 of carrier elements 150, the frame structure may be secured by means of glue applied in advance or afterwards to alignment pins 153 and/or spacer elements 151 . Alternatively or in addition, a separate element (not shown) for holding the frame structure 140 (e.g. by means of a spring force) may be provided.

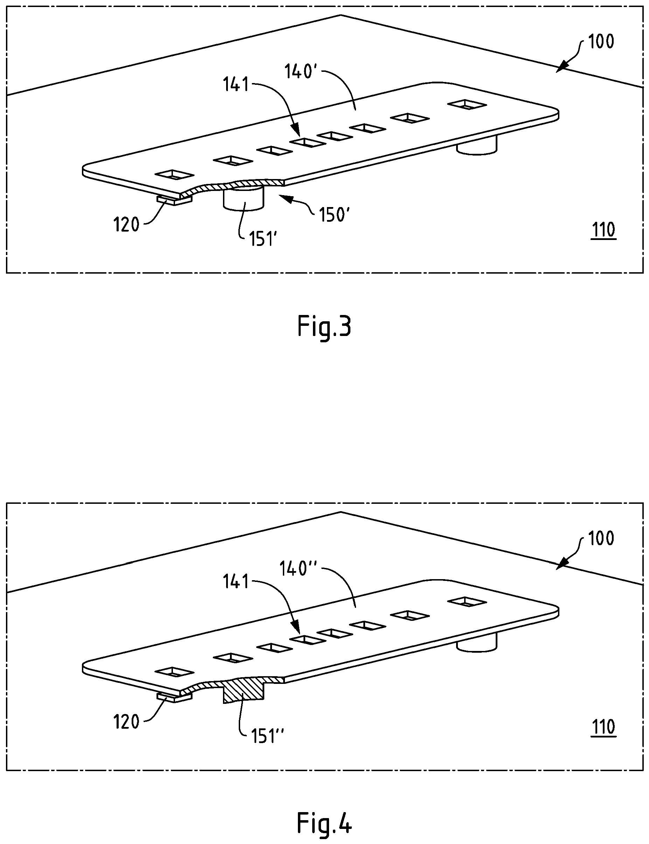

Fig. 3 shows aspects of a lighting device 100 with a frame structure 140' and carrier elements 150' according to a further embodiment. As shown, carrier elements 150' are not provided with alignment pins and frame structure 140' does not comprise alignment holes. Instead, as illustrated in the cut section at the figure's front, carrier elements 150' are separate members essentially consisting of spacer elements 151' comprising a flat top surface onto which a lower surface of frame structure 140' is secured, e.g. by gluing or by a spring force holder (the cut section is only for illustrative purposes to enable view onto spacer element 151'). In order to precisely align the supporting openings 141 of frame structure 140' with respect to the light emitting surfaces 121 of light emitting elements 121, on mounting, the frame structure can be actively aligned, e.g. under optical control, e.g. by using a camera. It is noted that this process can be an automatized alignment process.

Fig. 4 shows aspects of a lighting device 100 with a frame structure 140" and spacer elements 151" according to yet a further embodiment. As indicated by the cut section at the figure' front, in this embodiment, the frame structure 140" and the spacer elements 151" are integrally formed such that the frame structure 140" can be directly mounted to the PCB 110 e.g. by gluing or soldering the integral spacer elements 151" to PCB 110. In the shown case, the frame structure 140" and the spacer elements 151" may be for example milled from bulk material, e.g. from a piece of metal or plastic. Alternatively, a similar construction may be achieved by forming a frame structure and spacer elements from a single piece of sheet metal where e.g. edges and/or corners are bent to form the spacer elements.

Although the present invention has been disclosed in the form of preferred embodiments and variations thereon, it will be understood that numerous additional modifications and variations could be made thereto without departing from the scope of the invention as defined by the claims. For the sake of clarity, it is also to be understood that the use of "a" or "an" throughout this application does not exclude a plurality, and "comprising" does not exclude other steps or elements. Also, a "unit" and a "step" may comprise a number of components, unless explicitly described as a single entity.

### LIST OF REFERENCE SIGNS:

- 100: Lighting device
- 110: Printed circuit board
- 120: Light emitting diode
- 121: Light emitting surface
- 123: Solder connection
- 130: Light guide
- 131: Light input face
- 140, 140', 140": Frame structure
- 141: Supporting openings
- 143a: First alignment opening
- 143b: Openings
- 145: Second alignment opening
- 150, 150': Carrier element
- 151, 151', 151": Spacer element
- 153: Alignment pin
- 160: Glass separator sheet
- 601, z: Vertical direction
- 603, x: One lateral direction

## Claims

1. A lighting device (100), comprising:
- a base structure (110);
- at least one light emitting element (120) arranged on the base structure (110);
- at least one optical element (130) assigned to the at least one light emitting element (120);
- a frame structure (140) configured to define at least a lateral position of the at least one optical element (130) relative to the at least one light emitting element (120);
- wherein the frame structure (140) is mounted to the base structure (110) and configured to support the at least one optical element (130) at least in lateral alignment with the at least one light emitting element (120).

2. The lighting device (100) according to claim 1, further comprising at least one spacer element (151, 151', 151") mounted to the base structure (110), wherein the frame structure (140) is mounted to the base structure (110) via the at least one spacer element (151, 151', 151") at a distance from the base structure (110) defined by the at least one spacer element (151, 151', 151").

3. The lighting device (100) according to claim 2, wherein the base structure (110) comprises an essentially flat mounting portion onto which the at least one light emitting element (120) is mounted, and wherein the frame structure (140) is arranged essentially parallel to the mounting portion at the distance defined by the at least one spacer element (151, 151', 151").

4. The lighting device (100) according to any of claims 1 and 2, wherein the frame structure (140) comprises at least one supporting opening (141) configured to support the at least one optical element (130) at least in lateral alignment with the at least one light emitting element (120).

5. The lighting device (100) according to any of claims 2 or 3, wherein the frame structure (140) comprises at least one alignment opening (143a, 143b, 145) and wherein the at least one spacer element (151) comprises at least one guiding element (153) which extends from the at least one spacer element (151) through the at least one alignment opening (143a, 143b, 145).

6. The lighting device (100) according to claim 5, wherein the frame structure (140) comprises at least one first alignment opening (143a) configured to prevent relative movement of a first guiding element (153) extending from a first spacer element (151) through the at least one first alignment opening (143a) and at least one second alignment opening (145) configured to guide a relative movement of a second guiding element (153) extending from a second spacer element (151) through the at least one second alignment opening (145) within a predefined range.

7. The lighting device (100) according to claim 6, wherein the at least one second alignment opening (145) is essentially slot shaped.

8. The lighting device (100) according to claim 5, wherein the at least one guiding element (153) is formed integrally with the at least one spacer element (151).

9. The lighting device (100) according to any of claims 2 or 3, wherein the at least one spacer element (151 ") is formed integrally with the frame structure (140).

10. The lighting device (100) according to any of claims 1 or 2, wherein the at least one optical element (130) comprises a micro-collimator light guide arranged in direct or indirect mechanical contact with a light emitting surface (121) of the at least one light emitting element (120).

11. The lighting device (100) according to any of claims 1 or 2, comprising
- a plurality of light emitting elements (120) forming a matrix arrangement on the base structure (110);
- a plurality of optical elements (130), wherein each of the optical elements (130) is assigned to a corresponding one of the plurality of light emitting elements (120) and wherein the plurality of optical elements (130) forms a matrix arrangement in correspondence with the matrix arrangement of the plurality of light emitting elements (120);
- wherein the frame structure (140) comprises a plurality of supporting openings (141), each supporting opening (141) supporting a corresponding one of the plurality of optical elements (130) at least in lateral alignment with the respective one of the plurality of light emitting elements (120); and
- wherein each of the optical elements (130) comprises a light guide arranged in direct or indirect mechanical contact with a light emitting surface (121) of a corresponding one of the plurality of light emitting elements (120).

12. A method for manufacturing a lighting device (100) according to any of claims 1 to 11, the method comprising:
- providing the base structure (110);
- arranging the at least one light emitting element (120) on the base structure (110);
- providing the at least one optical element (130) assigned to the at least one light emitting element (120);
- providing the frame structure (140) configured to define at least the lateral position of the at least one optical element (130) relative to the at least one light emitting element (120); and
- mounting the frame structure (140) to the base structure (110) to support the at least one optical element (130) at least in lateral alignment with the at least one light emitting element (120).

13. The method according to claim 12, further comprising:
- mounting at least one spacer element (151, 151', 151") to the base structure (110) using a surface-mount technology mounting process; and
- mounting the frame structure (140) to the base structure (110) via the at least one spacer element (151, 151', 151") at a distance from the base structure (110) defined by the at least one spacer element (151, 151', 151").

14. The method according to claim 13, wherein mounting the frame structure (140) to the base structure (110) further comprises:
- guiding at least one guiding element (153) which extends from the at least one spacer element (151) through a corresponding alignment opening (143a, 143b, 145) of the frame structure (140).

15. The method according to claim 13, wherein mounting the frame structure (140) to the base structure (110) further comprises:
- attaching a surface of the frame structure (140) to a corresponding surface of the at least one spacer element (151, 151') by soldering or gluing.
